# EUROPEAN PATENT APPLICATION

(11) **EP 1 906 495 A1**
(43) Date of publication of application: **02.04.2008**
(21) Application number: 07018836.2
(22) Date of filing: 25.09.2007
(51) Int. Cl.: H01S 3/00, G02B 5/22, G02B 27/09, G02B 26/12, H01S 5/00

(54) **Shaping of a LD beam to reduce side lobs**

(30) Priority: 29.09.2006 JP 2006268225
(71) Applicant: FUJIFILM Corporation, Minato-ku Tokyo (JP)
(72) Inventor: Miyagawa, Ichirou, Kaisei-machi Ashigara-kami-gun Kanagawa (JP)
(74) Representative: Klunker . Schmitt-Nilson . Hirsch

(57) **Abstract**

The semiconductor laser light (10) source unit includes a semiconductor laser light source (12) for emitting a light beam having a great radiation angle in one direction, a collimator lens (14) for substantially collimating the light beam emitted from the light source, and a concentration distribution filter (18) positioned downstream of the collimator lens (14) in a traveling direction of the light beam and having a concentration distribution such that a concentration gradually increases in the one direction from a center of an optical axis of the light beam that has passed through the collimator lens (14). The filter (18) is tilted (e) about an axis perpendicular to the optical axis and to the one direction. Alternatively, the unit further includes a first rotational adjustment mechanism (70) that rotates for adjustment the filter (18) about the axis.

## Description

The entire contents of documents cited in this specification are incorporated herein by reference.

### BACKGROUND OF THE INVENTION

The present invention relates to a semiconductor laser light source unit capable of reducing side lobes generated as a light beam emitted from the semiconductor laser light source is condensed or converged and a method of reducing side lobes of a light beam, more specifically, to a semiconductor laser light source unit capable of reducing the side lobes due to, for example, diffracted light occurring near edges of a collimator lens and wavefront distortion generated at edges of the collimator lens, as the beam emitted from the semiconductor laser light source is converted into a substantially parallel beam by the collimator lens and a method of reducing side lobes of a light beam using the same. The present invention relates in particular to a semiconductor laser light source unit that suits an application in which it is used in an inner drum type photolithography machine or inner surface scanning type light beam scanning photolithography machine and a method of reducing side lobes of a light beam.

Generally, the offset printing, i.e., lithography, or photolithography, uses a photosensitive lithographic printing plate, or a presensitized plate (hereinafter referred to as "PS plate"). In the field of lithography, a computer-to-plate system, or a CTP system, has been put to practical use. In the CTP system, a printing plate is made directly from a procedure comprising a laser exposure processing that is performed according to digital data produced by a computer or other means, followed by a development processing to convert a latent image formed on a PS plate into a visible image using an automatic developer.

The CTP system as described above typically uses a so-called inner drum type exposure system or inner surface light beam scanning type exposure system whereby a scan exposure processing is performed by directing a light beam such as a laser beam to the photosensitive surface of a PS plate, i.e., a recording medium, deposited on the inner surface of the drum.

The inner drum type exposure system generally comprises a light source unit, a condenser lens or a converging lens, a monogon, a subscan moving means, and a drum having a PS plate, namely a recording medium, deposited therein.

The light source unit converts the light beam emitted from a semiconductor laser (LD) into a substantially parallel beam through an optical system comprising a collimator lens.

The condenser or converging lens converts the parallel beam to a condensed (or converged) beam and irradiate the monogon with the condensed beam.

The monogon comprises a reflector to admit and reflect the condensed beam emitted from the LD light source and a spinner to rotate the reflector at a high speed. The subscan moving means moves the monogon in the direction of the axis of the drum passing through the center of the arc the drum represents. The monogon allows the condensed beam emitted from the LD light source to incident to and reflected from the reflector rotating at a high speed, and the photosensitive surface of the PS plate deposited on the inner surface of the drum is scan-exposed in the main scanning direction with the reflected condensed beam, as well as the monogon and the reflected condensed beam are moved (sub-scanned) at a constant speed in the direction of the axis of the drum passing through the center of the arc of the drum in the sub scanning step, thus achieving exposure of the entire photosensitive surface of the PS plate.

Generally, a light beam emitted from a semiconductor laser light source radiates at a given angle with respect to the direction in which said light beam travels and therefore needs to be converted into a substantially parallel beam by a collimator lens (see JP 63-51687 A).

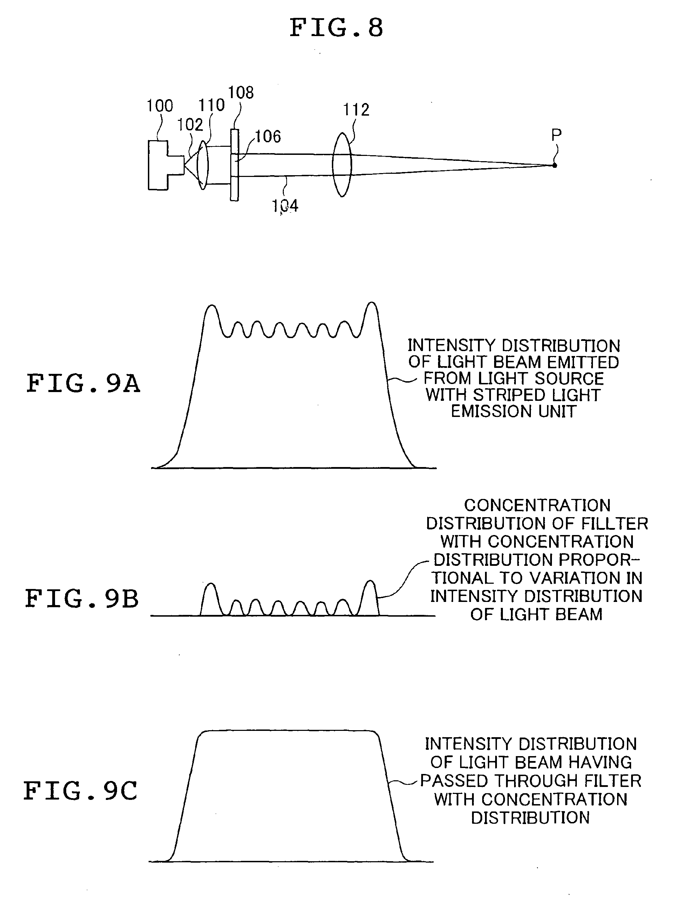

JP 63-51687 A, filed by the Applicant of the present patent application, discloses providing a light amount adjusting plate 108 between a collimator lens 110 and a condenser lens 112. As illustrated in Fig. 8, the light amount adjusting plate 108 has an aperture 106 that only permits the passage of a central light beam 104 of a light beam 102 emitted from a semiconductor laser light source 100. Thus, even in cases where the light beam 102 is a spontaneously emitted light beam having a low output range that diverges to a great extent or a laser emitted light beam with a slightly varying divergence, adverse effects produced by light beams having such dispositions can be avoided and the spot to which the beam condenses or converges has a constant diameter.

JP 10-31820 A proposes a method of reducing the variation in the intensity distribution of a light beam emitted from a semiconductor laser light source to use a high-output semiconductor laser light source that has a striped light emission unit and whose near field pattern exhibits a variation in intensity distribution, for initializing the medium surface of optical disks.

The above prior art discloses an optical disk initializing system has, on an optical path downstream of the collimator lens, a filter featuring a concentration distribution as illustrated in Fig. 9B that matches or is proportional to the intensity distribution or intensity variation as illustrated in Fig. 9A of a light beam emitted from the semiconductor laser light source having a striped light emission unit. Thus, a light beam free from variation in the intensity distribution is produced as illustrated in Fig. 9C, and is used to initialize the medium surface of optical disks.

### SUMMARY OF THE INVENTION

When a light beam emitted from a semiconductor laser light source is condensed , side lobes are produced adjacent the light beam in a direction in which the radiation angle of said light source is great.

The generation of these side lobes may be explained as follows.

When the light beam emitted from the semiconductor laser light source is converted into a substantially parallel beam through a collimator lens, diffracted light occurs near edges of the collimator lens due to vignetting, and/or the wavefront of the light beam is distorted because of the distortions at the edges of the collimator lens. Thus, when a light beam containing diffracted light and/or having wavefront distortion is condensed or converged, side lobes are produced adjacent the convergence spot due to the diffracted light and/or wavefront distortion.

In recent years, demand for higher picture quality in the field of lithography calls for uniform recording using frequency modulated screening. However, because photon mode sensitive materials such as a photo polymer sensitive material have a recording threshold near the bottom of the profile of the light beam at the convergence spot, problems are presented with such materials: recording is also made in areas supposed to remain unexposed depending on the quantity of the side lobes; and recorded images are prone to unevenness because the quantity of light near the bottom of the profile of the light beam at the convergence spot is easily varied even by a disturbance in the air on the optical path. The unevenness in the recorded images due to side lobes was a problem of great importance especially in the case of an exposure system of a type such as the inner drum type exposure system described above, wherein the monogon rotates the reflector at a high speed and is thus liable to develop disturbance in the air on the optical path.

The technology described in JP 63-51687 A reduces the diffracted light occurring at the collimator lens and thus reduces the side lobes. The reduction of the diffracted light thus achieved, however, is limited and the prior art does not disclose, nor does it imply reduction of, for example, wavefront distortion attributable to distortions located inside the collimator lens or those caused by comas.

JP 10-31820 A describes eliminating the variation in the intensity distribution inherent in the major light beam emitted from the semiconductor laser light source having a striped light emission unit by means of the filter having a concentration distribution that matches the intensity distribution of the light beam, as illustrated in Fig. 9A, 9B and 9C. However, JP 10-31820 A is totally ignorant of and even fails to imply occurrences of, for example, side lobes adjacent the major light beam, diffracted light caused by vignetting near the edges of the collimator lens, and the wavefront distortion attributable to distortions located inside the collimator lens or to other causes, these diffracted light and the wavefront distortion in turn causing the side lobes, when the light beam emitted from the semiconductor laser light source is converted into a substantially parallel beam through the collimator lens. Much less does the prior art disclose nor imply reduction thereof.

In an effort to limit the occurrence of side lobes, the semiconductor laser light source and the collimator lens were assembled and adjusted conventionally by inserting a wedge member, which was selected by trial and error, between the semiconductor laser light source and the collimator lens, or by using a collimator lens with a great numerical aperture (NA) but any of these methods failed to adequately limit the side lobes.

These approaches failed because semiconductor laser light sources and collimator lenses each have an individual difference and there is a limit to what assembly adjustments can do, and thus the side lobes will vary in magnitude anyway. Given, for example, that a peak intensity is 100 %, side lobes with an intensity of about 10 % could arise and could not be limited.

An object of the present invention is to provide a semiconductor laser light source unit that solves the above problems conventionally encountered and which, as a light beam emitted from the semiconductor laser light source is converted into a substantially parallel beam through a collimator lens, can reduce diffracted light occurring near the edges of the collimator lens and wavefront distortion occurring at the edges of the collimator lens, among others, and thus reduce the side lobes that are generated as the light beam emitted from the semiconductor laser light source unit is condensed

Another object of the present invention is to provide a semiconductor laser light source unit capable of emitting a light beam free from flare such as fed-back light caused by optical members used on the optical path, having a substantially circular cross section free from distortion, and from which only a small light amount is cut.

Further object of the present invention is to provide a method of reducing side lobes of a light beam emitted from a semiconductor laser light source unit.

To solve the above problems, the present invention provides a semiconductor laser light source unit comprising:
a semiconductor laser light source for emitting a light beam having a great radiation angle in one direction;
a collimator lens for substantially collimating the light beam emitted from the semiconductor laser light source; and
a concentration distribution filter positioned downstream of the collimator lens in a traveling direction of the light beam and having a concentration distribution such that a concentration gradually increases in the one direction from a center of an optical axis of the light beam that has passed through the collimator lens,
wherein the concentration distribution filter is tilted about an axis perpendicular to the optical axis of the light beam and to the one direction, or
wherein the semiconductor laser light source unit further comprises a first rotational adjustment mechanism that rotates for adjustment the concentration distribution filter about the axis perpendicular to the optical axis of the light beam and to the one direction.

The "one direction" herein means the direction in which the radiation angle of the light beam emitted by the semiconductor laser light source is great. "Rotating for adjustment" means rotating an inclination angle of the concentration distribution filter for adjustment.

The concentration distribution filter is preferably provided to reduce diffracted light and wavefront distortion occurring at an aperture of the collimator lens to 1/2 or less.

The semiconductor laser light source unit preferably further comprises a first apertured plate positioned downstream of the concentration distribution filter in the traveling direction of the light beam and having a substantially circular aperture.

The semiconductor laser light source unit preferably further comprises a second rotational adjustment mechanism for rotating for adjustment the first apertured plate about an axis perpendicular to the optical axis and to a rotational axis of the concentration distribution filter.

The semiconductor laser light source unit preferably further comprises a beam shaping optical system for producing a conjugate image of a part vignetted at the collimator lens, the beam shaping optical system being provided between the collimator lens and the concentration distribution filter,
wherein the concentration distribution filter is located in a substantially conjugate position relative to the part vignetted at the collimator lens with respect to the beam shaping optical system.

The beam shaping optical system preferably shapes the light beam into a light beam having a substantially circular cross section and a given beam diameter after passing through the concentration distribution filter.

The "given beam diameter" herein means a beam diameter suitable for causing the light beam to enter the condenser lens when condensing the light beam through a condenser lens system to cause an image to be formed for scan exposure.

The beam shaping optical system preferably condenses and then diverges the light beam that has passed through the collimator lens.

The beam shaping optical system preferably comprises:
a condenser lens for condensing the light beam having passed through the collimator lens;
a first cylindrical lens located in a position where the light beam diverges after being condensed through the condenser lens to adjust the light beam to the given diameter in the one direction; and
a second cylindrical lens located in a position where the light beam diverges after being condensed through the condenser lens to adjust the light beam to the given diameter in a direction perpendicular to the one direction,
wherein the light beam that has passed through the first and the second cylindrical lenses is adjusted to have a substantially circular cross section with the given beam diameter after passing through the concentration distribution filter.

The beam shaping optical system is preferably a relay lens system.

The semiconductor laser light source unit preferably further comprises a second apertured plate having an aperture that only passes the light beam emitted from the semiconductor laser light source and blocks a fed-back light reflected by the concentration distribution filter.

In the beam shaping optical system in which the light beam is condensed through the collimator lens, then diverged, and shaped to have the substantially circular cross section with the given diameter, the second apertured plate is preferably located in a position where the light beam is condensed to a maximum degree.

The present invention also provides a method of reducing side lobes of a light beam generated when the light beam having a great radiation angle in one direction emitted from a semiconductor laser light source and substantially collimated by a collimator lens is condensed, comprising the steps of:
rotating for adjustment a concentration distribution filter positioned downstream of the collimator lens in a traveling direction of the light beam and having a concentration distribution such that concentration gradually increases in the one direction from a center of an optical axis of the light beam that has passed through the collimator lens, the concentration distribution filter being rotated for adjustment about an axis perpendicular to the optical axis and to the one direction, the adjustment being made observing magnitude of the side lobes contained in the light beam.

The method of reducing the side lobes of the light beam preferably further comprises the steps of:
rotating for adjustment a first apertured plate positioned downstream of the concentration distribution filter in the direction of the light beam and having a substantially circular aperture about an axis perpendicular to the optical axis and to a rotational axis of the concentration distribution filter.

Thus, the present invention provides a semiconductor laser light source unit capable of reducing diffracted light occurring near edges of a collimator lens and wavefront distortion generated at edges of the collimator lens, as the beam emitted from the semiconductor laser light source is converted into a substantially parallel beam by the collimator lens, and hence, capable of reducing side lobes occurring as the light beam emitted from the semiconductor light source unit is condensed

Further, the present invention provides a semiconductor laser light source unit capable of emitting a light beam free from flare such as fed-back light caused by optical members used on the optical path, having a substantially circular cross section free from distortion, and from which only a small light amount is cut.

The inventive semiconductor laser light source unit comprises a concentration distribution filter downstream of the collimator lens in the direction of travel of the light beam emitted from the semiconductor laser light source (referred to simply as "laser light source" or "light source" below). The concentration distribution filter has a concentration distribution such that the concentration gradually increases from the center of the optical axis of the light beam in a direction in which the radiation angle is great. The concentration distribution filter is supported by a mechanism that rotates for adjustment about an axis perpendicular to the optical axis of the light beam and to the direction in which the radiation angle of the light beam is great. The side lobes produced because of the diffracted light occurring near edges of the collimator lens and/or wavefront distortion generated at the collimator lens, as a light beam emitted from the laser light source unit is condensed, can be reduced by rotating the concentration distribution filter to make adjustments thereof.

Further, in an embodiment of the present invention comprising a first apertured plate and a mechanism for rotating the apertured plate for adjustment, the light beam having passed through the concentration distribution filter can be shaped to have a substantially circular cross section by rotating the apertured plate to adjust the diameter of the light beam having passed through the concentration distribution filter in a direction perpendicular to the direction in which the radiation angle of the light beam with the optical axis of the light beam is great, i.e., in a direction in which the radiation angle is small.

Further, in an embodiment of the present invention comprising a beam shaping optical system such as a relay lens system, conjugate images produced close to edges of the collimator lens, such as diffracted light occurring near its edges and/br wavefront distortion generated at its edges, can be reproduced in the position where the concentration distribution filter is located. Thus, such diffracted light and wavefront distortion, for example, can be reduced more sufficiently and efficiently by the concentration distribution filter, and hence, the side lobes can be reduced more sufficiently. Furthermore, the light beam can be shaped to have a substantially circular cross section before entering the concentration distribution filter. Thus, the side lobes can be sufficiently reduced to produce a light beam shaped to have a substantially circular cross section and hence suited to be used for exposure.

Still further, in an embodiment of the present invention comprising a second apertured plate in the beam shaping optical system, fed-back light reflected by a surface of the concentration distribution filter and returning toward the laser light source can be blocked. Thus, generation of optical feedback noise can be prevented.

Further still, the inventive semiconductor laser light source unit having the above effects, when applied to an inner drum exposure system, is capable of exposing recording media such as PS plates with a light beam of which the side lobes are reduced even when the output of the laser light source is increased. Thus, a high-quality printing plate bearing an appropriate halftone dot image, hence high picture-quality and high product-quality prints free from image degradation, can be obtained without the possibility that recording is also made in areas supposed to remain unexposed even when a photon mode sensitive material such as a photo polymer sensitive material known to have a recording threshold near the bottom of the profile of the light beam at the convergence spot is used.

### BRIEF DESCRIPTION OF THE DRAWINGS

The invention will be better understood by reference to the following description taken in conjunction with the accompanying drawings in which:
Fig. 1 is a schematic drawing to explain an embodiment of an inner drum type exposure system to which the inventive semiconductor laser light source unit is applied.
Fig. 2 is a schematic drawing to explain an exposure optical system used in an embodiment of the inventive laser light source unit as applied to the inner drum type exposure system of Fig. 1 and the shapes of the light beam, i.e., intensity distribution configurations, as observed at the individual optical components shown.
Figs. 3A is a schematic front view of a concentration distribution filter used in the laser light source unit illustrated in Fig. 2; Fig. 3B is a graph illustrating the light transmittance of the filter.
Fig. 4 is a graph illustrating a distribution of the concentration distribution filter of Fig. 3A, the shape of a light beam that enters and passes through the filter, and the positional relationship in which diffracted beam irradiates the concentration distribution filter.
Fig. 5 is a perspective view to explain a rotational adjustment assembly 70 for adjusting the tilt of the concentration distribution filter in the laser light source unit of Fig. 2.
Figs. 6A and 6B each schematically illustrate another embodiment of the inventive laser light source unit as applied to the inner drum type exposure system of Fig. 1. Fig. 6A illustrates a plane that contains the fast axis and the optical axis; Fig. 6B illustrates a plane that contains the slow axis and the optical axis.
Figs. 7A and 7B each schematically illustrate still another embodiment of the inventive laser light source unit as applied to the inner drum type exposure system of Fig. 1. Fig. 7A illustrates a plane that contains the fast axis and the optical axis; and Fig. 7B illustrates a plane that contains the slow axis and the optical axis.
Fig. 8 is a schematic drawing to explain an optical system using a conventional semiconductor laser light source unit.
Figs. 9A, 9B, and 9C are drawings to explain a conventional way to eliminate variation in the intensity distribution of a light beam.

### DETAILED DESCRIPTION OF THE INVENTION

Now, description will be made of a typical example in which the inventive semiconductor laser light source unit having means for reducing side lobes is applied to an inner drum type exposure system whereby a PS plate used for offset printing is exposed by laser radiation.

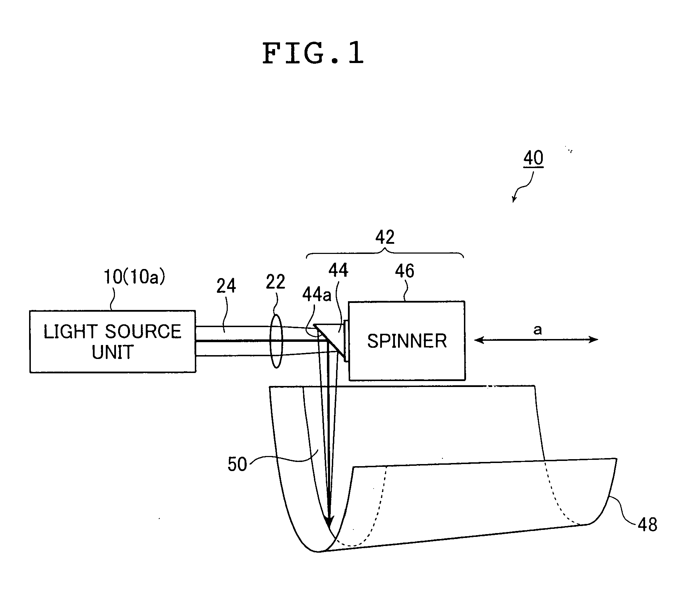

Fig. 1 is a schematic drawing to explain an embodiment of an inner drum type exposure system to which the inventive semiconductor laser light source unit is applied.

An inner drum type exposure system 40 illustrated in Fig. 1 comprises a semiconductor laser light source unit (hereinafter referred to simply as "light source unit") 10, a condenser lens system 22, a monogon 42, and a drum 48 having a PS plate 50 deposited therein.

The light source unit 10, which constitutes a key feature of the present invention, emits a light beam 24 produced by a laser light source such that its side lobes due to diffracted light, wavefront distortion, or other causes, are reduced. The light source unit 10 will be described later in more detail.

The condenser lens system 22 is a condensing or converging, and imaging lens provided to condense or converge the light beam 24 emitted with reduced side lobes from the inventive light source unit 10 to form an image on the PS plate 50 deposited on a concave surface of the drum 48. The configuration of the condenser lens system 22 is not limited to the illustrated typical example that is represented by a single convex lens. It may for example be an optical system of lenses constituted by a plurality of different lenses or an optical system of lenses comprising a plurality of different lenses and various optical members, a set of lenses, or an optical system of lenses comprising one or more sets of lenses.

The light beam 24 condensed by the condenser lens system 22 strikes the monogon 42.

The monogon 42 lies on the central axis of a substantial semi-cylinder providing a concave surface of the drum 48 of the inner drum type exposure system 40. The monogon 42 comprises a spinner 46.and a drive source (not shown), e.g., a motor, for rotating the spinner 46 at a high speed. The spinner 46 includes a reflector member 44 having a reflector surface 44a tilted by 45° on its top face. The spinner 46 is rotated at a high speed, e.g., 10,000 rpm or faster, by the drive source whose rotation is controlled by a spinner driver (not shown) of a controller (not shown). The axis of rotation of the spinner 46 lies on the central axis of the drum 48.

Thus, the light beam 24, which is emitted from the light source unit 10 with reduced side lobes and condensed by the condenser lens system 22, strikes the monogon 42 wherein the beam is reflected by the reflector surface 44a of the reflector member 44 to be polarized by 90° in order to expose the photosensitive surface, i.e., recording surface, of the PS plate 50 while the main scanning of the photosensitive surface of the PS plate 50 is performed using the light beam 24 that is polarized by the reflector member 44 as the reflector surface 44a rotates at a high speed.

The monogon 42 is moved to perform sub scanning at a constant speed by a subscan moving means (not shown) along the central axis of the drum 48 in the axial direction, i.e., the direction of arrow "a" illustrated in Fig. 1. The movement in the sub scanning direction i.e., the direction of arrow "a" illustrated in Fig. 1, of the monogon 42 achieved by the subscan moving means (not shown) is controlled by the controller (not shown) that also controls the spinner driver.

The inner drum type exposure system 40 is based on the drum 48 that provides the concave surface. The concave surface of the drum 48 is formed by the inner surface of the substantial semi-cylinder having an arc cross section. The PS plate 50 is deposited on the inner surface of the substantial semi-cylinder.

Before the inner drum type exposure system 40 performs the scan exposure described above, an unused PS plate 50 as a recording medium is deposited, in close contact, on the inner surface of the drum 48, using vacuum suction means (not shown).

The monogon 42 causes the light beam 24 emitted from the light source 10 and modulated in accordance with image data to reflect on the reflector surface 44a of the reflector member 44 rotating at a high speed to perform scan exposure in the main scanning direction. At the same time, the monogon 42 moves in the sub-scanning direction. Thus, the modulated light beam 24 reflected by the monogon 42 two-dimensionally scans and exposes the recording surface of the PS plate 50 deposited on the inner surface of the drum 48 to record a two-dimensional image on the entire recording surface of the PS plate 50.

Now the light source unit of the present invention will be described.

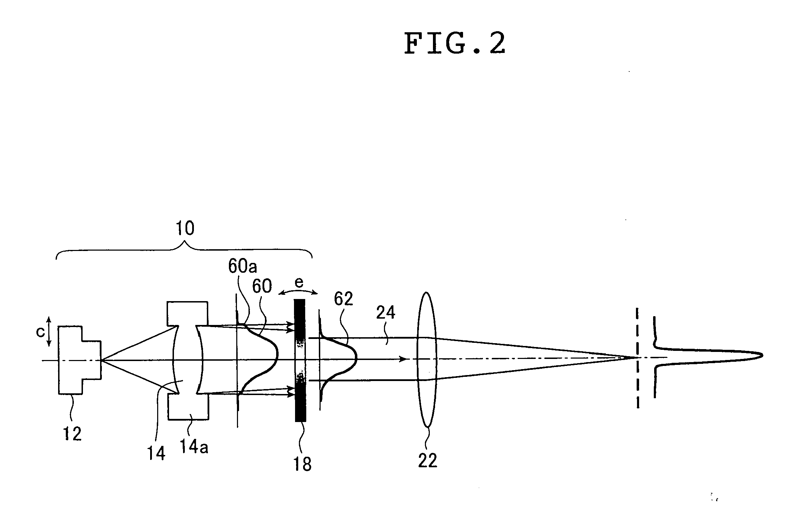

Fig. 2 is a schematic drawing to explain an exposure optical system used in an embodiment of the inventive laser light source unit and the shapes of the light beam i.e., intensity distribution configuration, as observed at the individual optical parts shown.

The illustrated light source unit 10 and the optical system for exposure using the light source unit 10 are used in the inner drum type exposure system 40 of Fig. 1. The light source unit 10 essentially comprises a laser light source 12, a collimator lens 14, and a concentration distribution filter 18.

The light source unit 10 emits the light beam 24 with reduced side lobes attributable to diffracted light, wavefront distortion, and other like causes occurring at the collimator lens 14 as it converts the light beam into a substantially parallel beam. This is achieved by admitting the light beam 24, which is emitted from the laser light source 12 and converted to a substantially parallel beam by the collimator lens 14, to the concentration distribution filter 18. Thus emitted from the light source unit 10 is a light beam with reduced side lobes suited to expose recording media.

The semiconductor laser (LD) light source 12 emits a coherent laser beam having a given wavelength capable of exposing recording media such as the PS plate 50. The light beam 24 thus emitted travels as it radiates in a direction perpendicular to the direction of travel at a given radiation angle. Generally, the radiation angle of the emitted light beam 24 with respect to the direction of travel is such that, as seen in a plane perpendicular to the direction of travel, the diameter is great in one direction and small in the direction perpendicular to the one direction. In other words, the light beam 24 represents a substantially elliptical shape in a plane perpendicular to the direction of travel.

The laser light source 12 used in the present invention may be any semiconductor laser light source, provided that it can emit a light beam by laser oscillation having a given wavelength capable of exposing recording media and that it uses a semiconductor laser (LD) device .

The collimator lens 14 converts the diffused light beam 24 emitted from the laser light source 12 into a substantially parallel beam. The collimator lens 14 is located near the laser light source 12 on the side thereof from which the light beam is emitted such that the center of the collimator lens 14 coincides with the center of the optical axis of the light beam 24 emitted from the light source 12. Preferably, the position of the collimator lens 14 in relation to the light source 12 is determined such that the focal point of the collimator lens 14 lies on the light emission plane of the light source 12.

The concentration distribution filter 18, constituting a feature of the present invention, reduces the side lobes 60a due, for example, to diffracted light occurring near the edges of the collimator lens 14, wavefront distortion generated at the edges of the collimator lens 14, and the wavefront distortion attributable to the semiconductor laser device itself of the laser light source 12, as the beam emitted by the semiconductor laser light source 12 is converted into a substantially parallel beam by the collimator lens 14.

The concentration distribution filter 18 is located downstream of the collimator lens 14 in the direction of travel of the light beam such that its center coincides with the center of the optical axis of the collimator lens 14. The tilt of the concentration distribution filter 18 in relation to the light beam 24 is adjusted to a given angle using a rotational adjustment assembly that rotates for adjustment about an axis (referred to as "slow axis" below) that is perpendicular both to the optical axis of the light beam 24 and to a direction (indicated by "c" in Fig. 2 and called "fast axis" below) in which the radiation angle with respect to the direction of travel of the light beam 24 is great, whereupon the tilt is fixed. The tilt of the concentration distribution filter 18 is adjusted by rotating it about the slow axis in the direction indicated by arrow "e" in Fig. 2 to minimize the side lobes 60a due to the diffracted light, wavefront distortion, and other like causes, occurring at the collimator lens 14. Thus, the concentration distribution filter 18 is disposed such that it is tilted at an angle with respect to the optical axis.

The rotational adjustment of the concentration distribution filter 18 for a plurality of light source units may be made starting with a posture in which the concentration distribution filter 18 is perpendicular to the optical axis of the light beam 24 by considering the magnitude of the side lobes 60a contained in the light beam 62 having passed through the concentration distribution filter 18. In any adjustment, wherein the tilt of the concentration distribution filter 18 is adjusted by rotating it by 20° to 30° from the above posture, the magnitude of the side lobes 60a will be reduced to 1% or less of the light beam 62 by adjusting .

The basic configuration and effects of one embodiment of the inventive semiconductor laser light source unit 10 has been described above. Next, description will be made of the concentration distribution filter, which is a key feature of the present invention, followed by description of the rotational adjustment assembly.

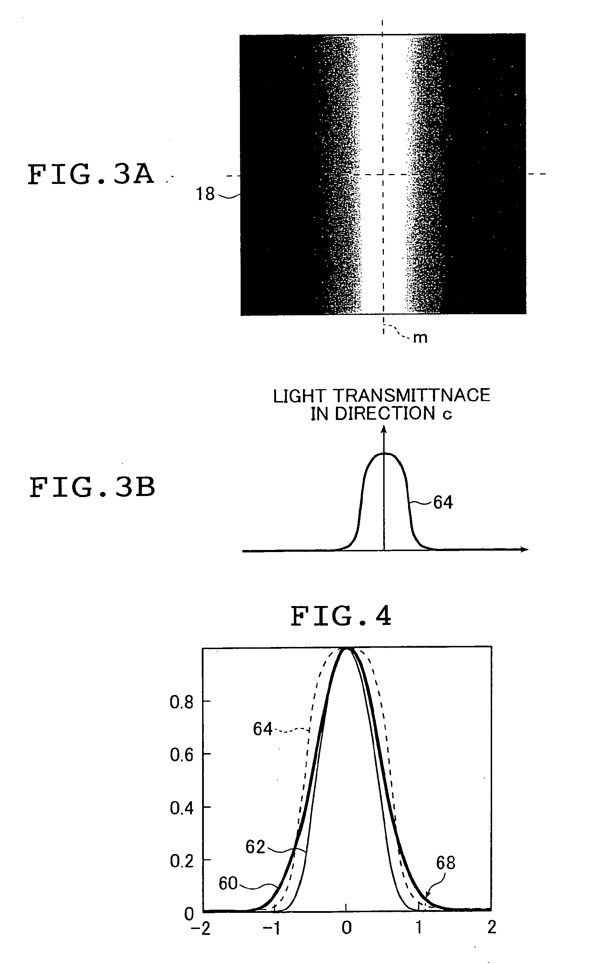

Now, the concentration distribution filter 18, a key feature of the embodiment under discussion, will be described in detail. As illustrated in Fig. 3A, the concentration distribution filter 18 is configured, for example, such that the concentration gradually increases or, in other words, the light transmittance gradually decreases, as the distance from the center thereof increases in one direction toward both sides. For example, the concentration distribution filter 18 may have a light transmittance as illustrated in Fig. 3B.

Providing the concentration distribution filter 18 in the location as described above reduces the side lobes caused by, for example, diffracted light occurring near the edges of the collimator lens and wavefront distortion generated at the edges of the collimator lens, as the beam emitted from the semiconductor laser light source is condensed. Further, the side lobes can be reduced regardless of the individual differences among laser light sources and collimator lenses used. This is achieved by adjusting the rotational position of the concentration distribution filter 18 specifically for each light source unit.

The diffracted light occurring near the edges of the collimator lens is caused to enter an area of the concentration distribution filter 18 having a high concentration, and reduced to a given value. The wavefront distortion generated at the edges, i.e., near the aperture, of the collimator lens is also reduced to a given value as it enters an area of the concentration distribution filter 18 having a high concentration.

In concentration distribution illustrated in Figs. 3A, the light transmittance gradually varies in one direction, i.e., in the horizontal direction in Fig.3A, from the center, where the light transmittance is high, toward the outer extremes, where the light transmittance is low, as will be seen from Fig. 3B. The light transmittance does not vary in the perpendicular direction, namely in the vertical direction in Fig. 3A.

According to the present invention, the concentration distribution filter 18 is positioned such that the direction in which its light transmittance varies coincides with the direction (direction indicated by "c" in Fig. 2) in which the radiation angle of the light beam 24 emitted from the light source 12 is great. In other words, the concentration distribution filter 18 is positioned such that the direction in which the radiation angle of the light beam 24 is great coincides with the horizontal direction of the concentration distribution filter 18 as seen in Fig. 3A.

According to the present invention, the concentration distribution filter 18 is adjusted by rotation to reduce the side lobes accompanying the light beam 24 to a desired value. To avoid side lobes that could otherwise be caused by the concentration distribution filter 18 itself, the concentration distribution filter 18 preferably has a light transmittance distribution that changes gradually unlike apertures 20a and 32a of a first apertured plate 20 and a second apertured plate 32 to be described.

Accordingly, the light transmittance of the concentration distribution filter 18 in the direction in which the radiation angle of the light beam 24 emitted from the light source 12 is great can be designed based on the shape the light beam 24 has before it passes through the concentration distribution filter 18 and a desired shape the light beam 24 assumes after it passes through the concentration distribution filter 18. In the embodiment under discussion, the light transmittance of the concentration distribution filter 18 may be designed, for example, such that the 1/e² beam diameter the light beam 24 assumes in the direction "c" after it passes through the concentration distribution filter 18 is 1.0 mm as compared with the 1/e² beam diameter 1.4 mm the light beam 24 has in the direction "c" before it passes through the concentration distribution filter 18.

The concentration distribution filter 18 used in the present invention has a light transmittance as indicated by a curve 64 in the graph of Fig. 3B, for example, and may be realized using linear, light absorption-type light-shielding films formed symmetrically with respect to the center line, e.g., center line "m" in Fig. 3A, such that they do not form clear edges. The concentration distribution filter 18 is not limited to this configuration; for example, a light-shielding film formed with dots that vary in size or density may be used instead of linear light-shielding films.

Methods of forming the concentration distribution filter 18 by giving it the light transmittance distribution as described above further includes one whereby a material having a given light transmittance (light absorption-type light shielding-film material) is adapted to have a thickness variation, and another using a light reflection-type light shielding-film material whereby a surface of the concentration distribution filter 18 is provided with a light reflection characteristics distribution as desired.

The concentration distribution filter 18 can reduce the side lobes 60a the light beam 60 has before it passes through the concentration distribution filter (see Fig. 2). This is achieved such that the side lobes 60a attenuate as they pass through the periphery of the concentration distribution filter 18 having a low light transmittance. As a result, the light beam 60, i.e., the light beam before passing through the concentration distribution filter 18, becomes the light beam 62, the light beam after passing through the concentration distribution filter 18 with the side lobes 60a reduced.

More specifically, as illustrated in Fig. 4, when the light beam 60 before passing through the concentration distribution filter 18 is incident to the concentration distribution filter 18 having a higher light transmittance in its center and a lower light transmittance in its periphery, a main part of the light beam incident to an area of the concentration distribution filter 18 near its center with a high light transmittance passes through the concentration distribution filter 18 with little attenuation to become the light beam 62, and the side lobes 60a which are parts of the light beam incident to a periphery of the concentration distribution filter 18 with a lower light transmittance attenuate and do not pass through the concentration distribution filter 18. As a result, the light beam 62 after being passed through the concentration distribution filter 18 becomes the light beam in which the side lobes 60a of the light beam60 attenuates.

The light source unit 10 according to the embodiment under discussion using the concentration distribution filter 18 as described above can reduce the side lobes 60a to 1/2 or less. When applied to the inner drum type exposure system 40, the light source unit 10 having such advantageous effects can expose recording media such as PS plates by means of the light beam of which the side lobes are reduced to 1/2 or less even when the laser light beam output is increased. Thus, it is ensured that areas of the PS plate supposed to remain unexposed are not exposed and, accordingly, a high-quality printing plate bearing an appropriate halftone dot image, hence high picture-quality and high product-quality prints free from image degradation, can be obtained.

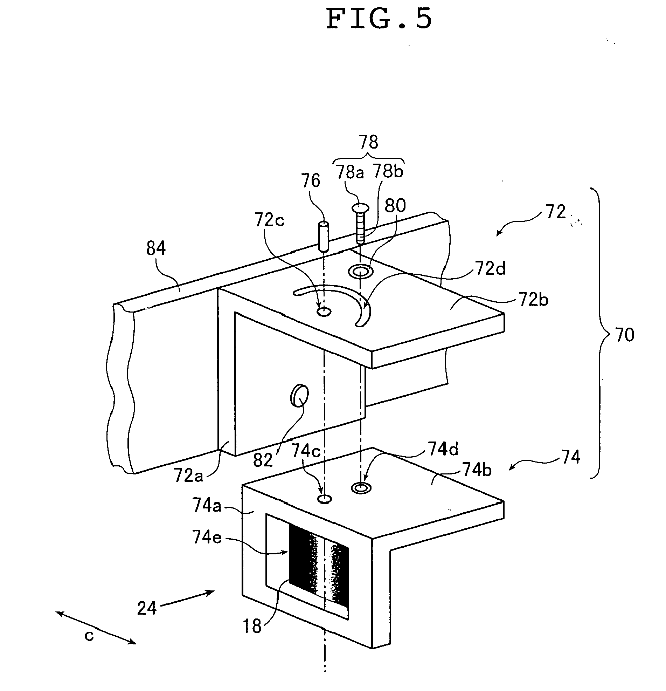

Now, description will be made of the rotational adjustment assembly 70 for adjusting the tilt of the concentration distribution filter 18 with respect to the light beam 24, i.e., for positioning and securing the tilt of the concentration distribution filter 18 at a given angle. Fig. 5 is a perspective view to explain the rotational adjustment assembly 70 for adjusting the tilt of the concentration distribution filter 18 in the light source unit illustrated in Fig. 2. The arrow indicating the light beam 24 and the arrow "c" indicating the fast axis direction in Fig. 5 correspond to the arrow indicating the light beam 24 and the arrow "c" indicating the fast axis direction in Fig. 2.

Referring to Fig. 5, the rotational adjustment assembly 70 comprises a mount 72, a holder 74, a pin 76, a screw 78, and a flat washer 80, and is secured by a screw 82 to a side wall 84 of the light source unit 10 that in turn is disposed substantially in parallel to the light beam 24.

The mount 72 is provided to suspend the holder 74 and has an L-shaped configuration having a vertically disposed flat plate section 72a connected with a horizontally disposed flat plate section 72b. The flat piste section 72b comprises a pin hole 72c through which a pin 76 serving as an axis to adjust the tilt of the holder 74 by rotation with respect to the light beam 24 is passed and an arc hole 72d through which the screw 78 for securing the holder 74 to a tilted position is passed. The pin hole 72c is at the center of the arc defined by the arc hole 72d.

The holder 74 is provided to hold the concentration distribution filter 18 or the first apertured plate 20 and adjust the tilt of either member with respect to the light beam 24. The holder 74 has an L-shaped configuration having a vertically disposed flat plate section 74a connected with a horizontally disposed flat plate section 74b. The flat plate section 74b is positioned immediately beneath the flat plate section 72b and in contact therewith. The flat plate section 74a has a window 74e for holding the concentration distribution filter 18 or the first apertured plate 20. In the embodiment under discussion, the concentration distribution filter 18 is adhered to the window 74e. The flat plate section 74b has a pin hole 74c through which the pin 76 is passed and a screw hole 74d to engage with the screw 78, the pin hole 74c being only open on the side of the flat plate section 74b facing the flat plate section 72b. The position of the pin hole 74c in the plane defined by the flat plate section 74b is in alignment with the center of the concentration distribution filter 18 or the first apertured plate 20.

The pin 76 is provided to determine the center of rotation of the holder 74 and the concentration distribution filter 18 or the first apertured plate 20, and is passed through the pin hole 72c of the mount 72 into the pin hole 74c of the holder 74.

The screw 78 is provided to secure the holder 74 to the mount 72 and has a screw head 78a and a screw thread 78b to engage with the screw hole 74d of the holder 74. The screw 78 engages with the screw hole 74d of the holder 74 such that the screw head 78a is located on the mount 72 side, with the flat washer 80 between them.

The screw 78 is loosened to allow rotation and adjustment of the tilt of the holder 74 and the concentration distribution filter 18 or the first apertured plate 20 with respect to the light beam 24. The screw 78 is tightened to fix the tilt of the holder 74 and the concentration distribution filter 18 or the first apertured plate 20 with respect to the light beam 24.

The rotational adjustment assembly used in the present invention may be configured in any manner, provided that it can adjust and fix the tilt of the concentration distribution filter 18 or the first apertured plate 20 with respect to the light beam 24. For example, a lens support mount, i.e., a known rotational adjustment mechanism, may be used to adjust the tilt with respect to the light beam 24, thereupon fixing the tilt with glue or other means.

As described later, the first apertured plate having a substantially circular aperture for shaping the light beam 24 that has passed through the concentration distribution filter 18 and a rotational adjustment mechanism that rotates the first apertured plate about an axis (referred to as "fast axis" below) perpendicular to the optical axis of the light beam 24 and the axis of rotation of the concentration distribution filter 18 may be provided downstream of the concentration distribution filter 18 such that the aperture of the first apertured plate is aligned with the light beam 24 that has passed through the concentration distribution filter 18.

Now, another embodiment of the inventive light source unit will be described.

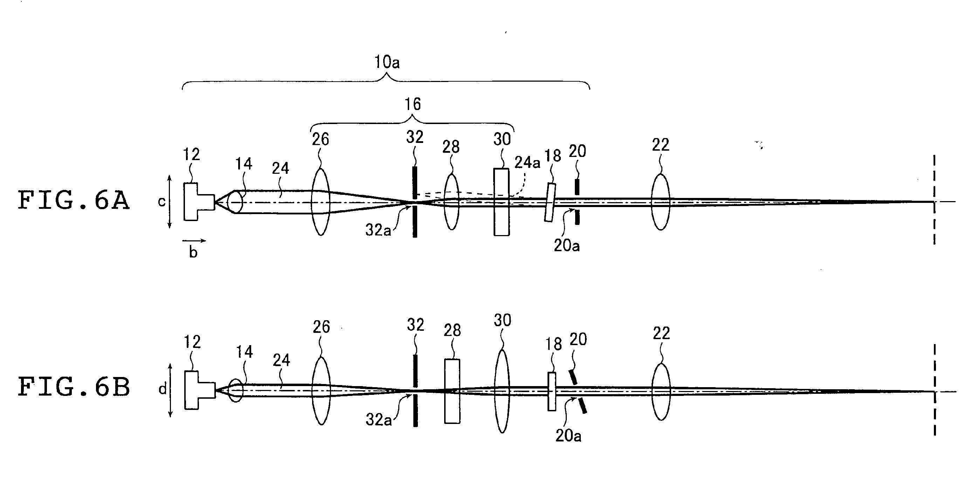

Figs. 6A and 6B schematically illustrate another embodiment of the inventive light source unit, each in a plane containing the fast axis and the optical axis and in a plane containing the slow axis and the optical axis, respectively.

A light source unit 10a according to the embodiment now to be described offers further advantages in addition to reduction of side lobes accompanying the light beam 24, whereby generation of optical feedback noise is prevented and the light beam 24 having passed through the concentration distribution filter 18 is shaped to have a given diameter.

The light source unit 10a illustrated in Figs. 6A and 6B has substantially the same configuration as the light source unit 10 shown in Fig. 2 except that the former additionally comprises a beam shaping optical system 16 and the first apertured plate 20. Like components are indicated by like reference numerals used in the previous relevant drawings, and are not described in detail here.

The light source unit 10a shown basically comprises the light source unit 12, the collimator lens 14, the beam shaping optical system 16, the concentration distribution filter 18, and the first apertured plate 20.

In the light source unit 10a, the light beam 24 emitted from the laser light source 12 and converted into a substantially parallel beam by the collimator lens 14 is condensed and diverged by the beam shaping optical system 16, followed by adjustment of the shape and diameter of the light beam. Then, the light beam 24 is admitted to the concentration distribution filter 18 to reduce the side lobes due to diffracted light occurring near the edges of the collimator lens and wavefront distortion generated at the edges of the collimator lens. The light beam with reduced side lobes is passed through the first apertured plate 20 in order to adjust the shape and diameter of the light beam 24. Thus, the light source unit 10a emits the light beam 24 having reduced side lobes and shaped to have a given beam diameter suited to expose recording media.

According to the embodiment under discussion, the light beam 24 emitted from the light source 12 and converted into a substantially parallel beam by the collimator lens 14 is passed through the beam shaping optical system 16 before it enters the concentration distribution filter 18, unlike in the embodiment shown in Fig. 2.

The beam shaping optical system 16 is provided to condense and then diverge the light beam 24 to shape it into a substantial circle with a given beam diameter before the light beam 24 enters the concentration distribution filter 18. The beam shaping optical system 16 comprises an upstream lens 26, a first cylindrical lens 28, a second cylindrical lens 30, and a second apertured plate 32.

The upstream lens 26 is a convex lens provided downstream of the collimator lens 14 in the direction of travel of the light beam (referred to simply as "downstream" below) to condense the substantially parallel beam having passed through the collimator lens 14. The upstream lens 26 and the collimator lens 14 are of course so positioned as to share the same optical axis.

The first cylindrical lens 28 is located downstream of the upstream lens 26 and on the same optical axis as the latter. The first cylindrical lens 28 has such a lens power as to condense the light beam only in the fast axis direction or direction "c" as indicated in Fig. 6A and does not have a lens power in the slow axis direction or direction "d" as indicated in Fig. 6B. The first cylindrical lens 28 converts the light beam 24, once condensed through the upstream lens 26 and thereafter diverged, into a parallel beam having a given diameter only in the fast axis direction. The first cylindrical lens 28 and the upstream lens 26 may be positioned such that these lenses are spaced apart by the sum of their focal distances.

The second cylindrical lens 30 is located downstream of the first cylindrical lens 28 and on the same optical axis as the latter. The second cylindrical lens 30 has such a lens power as to condense the light beam only in the slow axis direction as indicated in Fig. 6B and does not have a lens power in the fast axis direction as indicated in Fig. 6A. The second cylindrical lens 30 converts the light beam 24, which is previously condensed through the upstream lens 26, then diverged, and subsequently collimated through the first cylindrical lens 28 into a parallel beam having a given beam diameter only in the fast axis direction, into a parallel beam having a given diameter only in the slow axis direction. The second cylindrical lens 30 may be positioned with respect to the upstream lens 26 such that these lenses are spaced apart from each other by the sum of their focal distances.

Thus, the light beam 24, after passing through the first and second cylindrical lenses 28 and 30, is shaped into a parallel light beam having a substantially circular cross section and a given diameter in both the fast axis direction and the slow axis direction perpendicular thereto. Then, the light beam 24 having a cross section now shaped into a substantial circle enters the concentration distribution filter 18.

Thus, the light beam 24 that has passed through the collimator lens 14 can be shaped into a light beam having a substantially circular cross section through the beam shaping optical system 16 before the light beam 24 enters the concentration distribution filter 18.

According to the embodiment under discussion, the diameter of the light beam 24 can be adjusted both in the fast axis and the slow axis directions independently through the first and second cylindrical lenses 28 and 30. Thus, the light beam can be shaped into a light beam having a substantially circular cross section and a given beam diameter even when the light beam 24 entering the beam shaping optical system 16 has such an elliptical cross section that greatly deviates from a substantial circle.

The second apertured plate 32 has an aperture 32a of proper dimensions to admit the condensed light beam 24. The aperture 32a is located in a position where the light beam 24 having passed through the upstream lens 26 condenses to a maximum degree. The second apertured plate 32 passes the light beam traveling from the laser light source 12 toward the concentration distribution filter 18 but blocks the reflected light of the light beam 24 reflected by the surface of the concentration distribution filter 18, i.e., a fed-back light 24a traveling back toward the laser light source 12 indicated by a dotted line in Fig. 6A. Thus, optical feedback noise that could be generated if the fed-back light 24a should reach the laser light source 12 and could adversely affect the laser light source 12 can be prevented from occurring.

Thus, the light beam 24 shaped into a substantial circle through the beam shaping optical system 16 enters the concentration distribution filter 18. The side lobes caused by the diffracted light and wavefront distortion occurring as the light beam is converted into a substantially parallel beam by the collimator lens 14 can be reduced also in this embodiment, as in the embodiment illustrated in Fig. 2.

In the embodiment under discussion, the collimator lens 14 and the concentration distribution filter 18 may be disposed in conjugate positions with respect to the beam shaping optical system 16. In such arrangement, diffracted light due to vignetting occurring near the edges of the collimator lens and wavefront distortion generated at the edges, for example, can be reproduced in the position of the concentration distribution filter 18, and thus the concentration distribution filter 18 can further reduce the side lobes due to the diffracted light, wavefront distortion, and other like causes.

Also in the embodiment under discussion, the tilt of the concentration distribution filter 18 with respect to the light beam 24 is adjusted using the above-mentioned rotational adjustment assembly 70 that rotates about the slow axis to make adjustments. The tilt adjustment enables the concentration distribution filter 18 to reduce the side lobes.

Since the beam shaping optical system 16 comprises the second apertured plate 32 in the embodiment under discussion as described above, a non-aperture area of the second apertured plate 32 blocks the fed-back light 24a that travels back toward the laser light source 12 after being reflected by the surface of the concentration distribution filter 18 tilted at a given angle by rotation about the slow axis. Thus, generation of optical feedback noise can also be prevented.

Thus, the light beam 24 after passing through the concentration distribution filter 18 enters the first apertured plate 20, with sufficiently reduced side lobes caused by diffracted light and wavefront distortion occurring at the time of collimation whereby the light beam 24 is converted into a substantially parallel beam.

The first apertured plate 20 has a circular aperture 20a to adjust the beam diameter in the direction of the slow axis in which direction the diameter of the light beam 24 is not adjusted by the concentration distribution filter 18, in order that the diameter of the light beam 24 having passed through the tilted concentration distribution filter 18 may be adjusted to be substantially equal or, preferably, as close to each other as possible, both in the fast and slow axis directions. Located downstream of the concentration distribution filter 18, the first apertured plate 20 has the substantially circular aperture 20a aligned with the light beam 24. The tilt of the first apertured plate 20 with respect to the light beam 24 is adjusted by a rotational adjustment assembly that rotates about an axis (referred to as "fast axis" below) perpendicular to the optical axis of the light beam 24 and to the direction, in which the radiation angle with respect to the direction of travel of the light beam 24 is small, i.e., the direction "d" indicated in Fig. 6B.

A possible concern may be that the vignetting that occurs at the first apertured plate could generate diffracted light. However, the side lobes due to this diffraction assume an annular form at the spot where the beam condenses or converges and, hence, hardly poses any significant problem for recording unlike side lobes that stand out in the fast axis direction.

The light beam 24 grows thinner as the side lobes in the fast axis direction are reduced through the concentration distribution filter 18. However, since the beam diameter in the slow axis direction is not adjusted by concentration distribution filter 18, the light beam may have an elliptical cross section such that the beam diameter in the slow axis direction is greater than that in the fast axis direction. Accordingly, the edges of the light beam in the slow axis direction are cut off by the circular aperture 20a of the first apertured plate 20 to adjust the beam diameter in the slow axis direction. Thus, the light beam 24, having passed through the circular aperture 20a of the first apertured plate 20, assumes a substantially circular cross section having a substantially equal diameter both in the fast and slow axis directions.

The rotational adjustment of the tilt of the first apertured plate 20 for a plurality of light source units may be made starting with a posture in which the first apertured plate 20 is perpendicular to the optical axis of the light beam 24 and by observing the shape of the light beam 24 having passed through the first apertured plate 20. In any adjustment, wherein the first apertured plate 20 is rotated starting from the above posture, the light beam 24 having passed through the first apertured plate 20 will have a substantially circular cross section with a substantially equal diameter both in the fast and slow axis directions.

As described above, the light beam 24 having passed through the concentration distribution filter 18 assumes an elliptical cross section having a longer diameter in the slow axis direction as a result of the rotational adjustment of the concentration distribution filter 18 about the slow axis. The width of the light beam 24 in the slow axis direction with which it passes through the circular aperture 20a of the first apertured plate 20 can be adjusted by rotating the first apertured plate 20 about the fast axis. Thus, the diameter of the light beam 24 can be fine-tuned to make the cross section of the light beam 24 substantially circular.

The aperture 20a of the first apertured plate 20 may have any given diameter, provided that the vignetting occurring at the aperture 20a practically does not pose any problem. For example, suppose the 1/e² width of the light beam 24 in the direction "d" as it passes through the aperture 20a is 1.0 mm, the aperture 20a may have a diameter of 1.0 mm to 2.0 mm.

In the embodiment under discussion, therefore, even when the light beam 24 having passed through the concentration distribution filter 18 has an elliptical cross section deviating from a substantially circular cross section, part of the light beam having the elliptical cross section is cropped by the aperture 20a of the first apertured plate 20, such that the light beam 24 assumes a substantially circular cross section after passing through the aperture 20a. Thus, it is preferable to provide the first apertured plate 20.

According to the embodiment under discussion, the light beam 24 is shaped to a substantial circle in cross section by the beam shaping optical system 16 before the light beam 24 enters the concentration distribution filter 18. Therefore, the light beam 24 having passed through the concentration distribution filter 18 has a cross-sectional shape that deviates only slightly from a circle, and hence part of the light beam 24 that needs to be cropped by the first apertured plate 20 can be minimized or eliminated. Therefore, the light beam 24 emitted from the laser light source 12 can be emitted from the light source unit 10a with an enhanced efficiency.

Thus, when the light source unit 10a is provided with the beam shaping optical system 16, the cross-sectional shape of the light beam 24 deviates from a circle so slightly that when the cross section of the light beam 24 having passed through the tilted concentration distribution filter 18 does not significantly deviate from.a circle toward an ellipse, the first apertured plate 20 need not necessarily have the rotational adjustment means, or the first apertured plate 20 itself may be dispensed with altogether. However, since the part that needs to be cropped by the first apertured plate 20 is either small or null irrespective of the provision of the first apertured plate 20 either way, it is preferable to provide the first apertured plate 20. Also in the embodiment illustrated in Fig. 2, the first apertured plate 20 is of course positioned preferably downstream of the concentration distribution filter 18.

The light source unit 10a according to the embodiment under discussion is configured basically as described above.

In addition to reducing side lobes of the light beam 24, the light source unit 10a according to the embodiment under discussion can prevent generation of the optical feedback noise and shape the light beam 24 into a light beam having a given beam diameter through the concentration distribution filter 18.

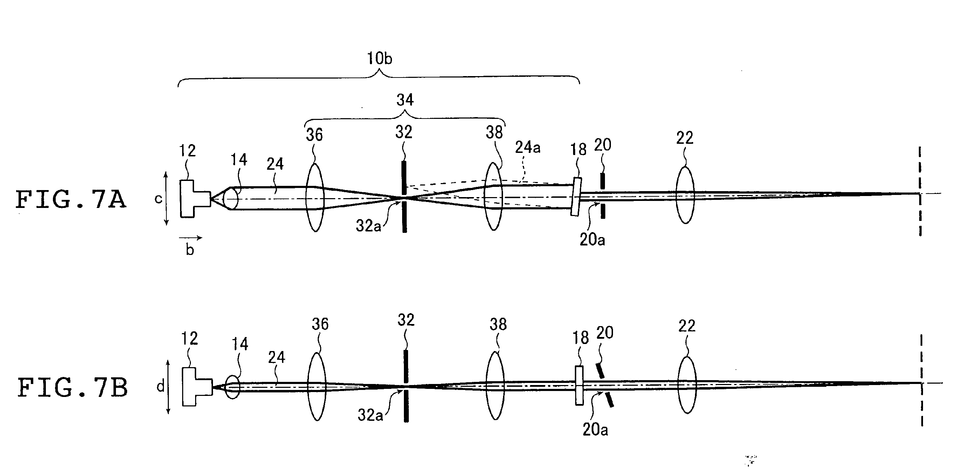

In the light source unit 10a illustrated in Figs. 6A and 6B, the beam shaping optical system 16 is composed of an optical system of lenses comprising the upstream lens 26, the first and second cylindrical lenses 28 and 30, and the second apertured plate 32. The present invention is not limited to this configuration however; the beam shaping optical system 16 may, for example, be constituted by a relay lens system 34 comprising a light source-side lens 36, a farther-from-light-source lens 38, and the second apertured plate 32 as in the case of a light source unit 10b illustrated in Figs. 7A and 7B.

Figs. 7A and 7B schematically illustrate still another embodiment of the inventive light source unit each in the plane containing the fast axis and the optical axis and in the plane containing the slow axis and the optical axis, respectively.

The light source unit 10b according to this embodiment prevents generation of optical feedback noise as well as reducing side lobes of the light beam 24 with a simple configuration as compared with the light source unit 10a.

The light source unit 10b illustrated in Figs. 7A and 7B shares substantially the same components as the light source unit 10a illustrated in Figs. 6A and 6B except that the light source unit 10b has the relay lens system 34 in place of the beam shaping optical system 16. Like components are indicated by like reference numerals used in the previous relevant drawings and will not be described in detail.

The light source unit 10b in the illustrated example basically comprises the laser light source 12, the collimator lens 14, the relay lens system 34, the concentration distribution filter 18, and the first apertured plate 20. As described above, the relay lens system 34 comprises the light source-side lens 36, the farther-from-light-source lens 38, and the second apertured plate 32.

In the light source unit 10b, the light beam 24 emitted from the light source 12 and converted into a substantially parallel beam by the collimator lens 14 is condensed and diverged, followed by adjustments of the shape and the diameter of the light beam 24 through the relay lens system 34, as in the light source unit 10a of Figs. 6A and 6B. Then, the light beam 24 is passed through the concentration distribution filter 18 to reduce its side lobes caused by, for example, diffracted light occurring near the edges of the collimator lens and wavefront distortion generated at the edges of the collimator lens. The light beam with reduced side lobes is passed through the first apertured plate 20 to adjust the shape and the diameter of the light beam 24. Thus emitted is the light beam 24 having reduced side lobes and shaped to have a given beam diameter, i.e., a beam diameter suited to expose recording media.

The light source side lens 36 of the relay lens system 34 has substantially the same functions as the upstream lens 26 of the beam shaping optical system 16 illustrated in Figs. 6A and 6B and is located in substantially the same position in the relay lens system 34 as the upstream lens 26 is located in the beam shaping optical system 16.

The farther-from-light-source lens 38 is a convex lens having the same focal distance as the light source side lens 36 and possesses lens power in both the fast axis direction indicated in Fig. 7A and the slow axis direction indicated in Fig. 7B, i.e., in all the radial directions contained in a plane perpendicular to the optical axis, which coincides with the center of the light beam. The farther-from-light-source lens 38 collimates the light beam 24 once condensed through the light source side lens 36 and then diverged. The light source side lens 36 and the farther-from-light-source lens 38 are of course so positioned as to share the same optical axis. The light source side lens 36 may be positioned with respect to the farther-from-light-source lens 38 such that these lenses are spaced apart from each other by the sum of their focal distances.

As in the light source unit 10a illustrated in Figs. 6A and 6B, the collimator lens 14 and the concentration distribution filter 18 in the light source unit 10b are preferably located in conjugate positions with respect to the relay lens system 34.

The second apertured plate 32, being substantially the same as the apertured plate of the beam shaping optical system 16 illustrated in Figs. 6A and 6B, is preferably placed in such a position that the aperture 32a is located where the light beam 24 condenses through the light source side lens 36 to a maximum degree.

The second apertured plate 32 passes the light beam traveling from the laser light source 12 toward the concentration distribution filter 18 but blocks the reflected light of the light beam 24 reflected by the surface of the concentration distribution filter 18, i.e., a fed-back light 24a traveling back toward the laser light source 12 indicated by a dotted line in Fig. 7A. Thus, generation of optical feedback noise that could be generated if the fed-back light 24a should reach the laser light source 12 and could adversely affect the laser light source 12 can be prevented. The light source unit 10b according to the embodiment under discussion prevents generation of optical feedback noise as well as reducing side lobes of the light beam 24 with a simple configuration as compared with the light source unit 10a.

While the light source unit according to the present invention has been described in detail by means of specific embodiments, it is to be understood that the present embodiments are illustrative and not restrictive and that numerous changes and modifications may be made therein without departing from the spirit and scope of the invention.

## Claims

1. A semiconductor laser light source unit comprising:
a semiconductor laser light source for emitting a light beam having a great radiation angle in one direction;
a collimator lens for substantially collimating said light beam emitted from said semiconductor laser light source; and
a concentration distribution filter positioned downstream of said collimator lens in a traveling direction of said light beam and having a concentration distribution such that a concentration gradually increases in said one direction from a center of an optical axis of said light beam that has passed through said collimator lens,
wherein said concentration distribution filter is tilted about an axis perpendicular to said optical axis of said light beam and to said one direction, or
wherein said semiconductor laser light source unit further comprises a first rotational adjustment mechanism that rotates for adjustment said concentration distribution filter about said axis perpendicular to said optical axis of said light beam and to said one direction.

2. The semiconductor laser light source unit according to Claim 1, wherein said concentration distribution filter is provided to reduce diffracted light and wavefront distortion occurring at an aperture of said collimator lens to 1/2 or less.

3. The semiconductor laser light source unit according to Claim 1 or 2, further comprising a first apertured plate positioned downstream of said concentration distribution filter in said traveling direction of said light beam and having a substantially circular aperture.

4. The semiconductor laser light source unit according to Claim 3, further comprising a second rotational adjustment mechanism for rotating for adjustment said first apertured plate about an axis perpendicular to said optical axis and to a rotational axis of said concentration distribution filter.

5. The semiconductor laser light source unit according to any one of Claims 1 to 4, further comprising
a beam shaping optical system for producing a conjugate image of a part vignetted at said collimator lens, said beam shaping optical system being provided between said collimator lens and said concentration distribution filter,
wherein said concentration distribution filter is located in a substantially conjugate position relative to said part vignetted at said collimator lens with respect to said beam shaping optical system.

6. The semiconductor laser light source unit according to Claim 5, wherein said beam shaping optical system shapes said light beam into a light beam having a substantially circular cross section and a given beam diameter after passing through said concentration distribution filter.

7. The semiconductor laser light source unit according to Claim 5 or 6, wherein said beam shaping optical system condenses and then diverges said light beam that has passed through said collimator lens.

8. The semiconductor laser light source unit according to any one of Claims 5 to 7, wherein said beam shaping optical system comprises:
a condenser lens for condensing said light beam having passed through said collimator lens;
a first cylindrical lens located in a position where said light beam diverges after being condensed through said condenser lens to adjust said light beam to said given diameter in said one direction; and
a second cylindrical lens located in a position where said light beam diverges after being condensed through said condenser lens to adjust said light beam to said given diameter in a direction perpendicular to said one direction,
wherein said light beam that has passed through said first and said second cylindrical lenses is adjusted to have a substantially circular cross section with said given beam diameter after passing through said concentration distribution filter.

9. The semiconductor laser light source unit according to any one of Claims 5 to 8, wherein said beam shaping optical system is a relay lens system.

10. The semiconductor laser light source unit according to any one of Claims 5 to 9, further comprising a second apertured plate having an aperture that only passes said light beam emitted from said semiconductor laser light source and blocks a. fed-back light reflected by said concentration distribution filter.

11. The semiconductor laser light source unit according to Claim 10, wherein, in said beam shaping optical system in which said light beam is condensed through said collimator lens, then diverge, and shaped to have the substantially circular cross section with said given diameter, said second apertured plate is located in a position where said light beam is condensed to a maximum degree.

12. A method of reducing side lobes of a light beam generated when said light beam having a great radiation angle in one direction emitted from a semiconductor laser light source and substantially collimated by a collimator lens is condensed, comprising the steps of:
rotating for adjustment a concentration distribution filter positioned downstream of said collimator lens in a traveling direction of said light beam and having a concentration distribution such that concentration gradually increases in said one direction from a center of an optical axis of said light beam that has passed through said collimator lens, said concentration distribution filter being rotated for adjustment about an axis perpendicular to said optical axis and to said one direction, said adjustment being made observing magnitude of said side lobes contained in said light beam.

13. The method of reducing the side lobes of the light beam according to Claim 12, further comprising the step of:
rotating for adjustment a first apertured plate positioned downstream of said concentration distribution filter in said direction of said light beam and having a substantially circular aperture about an axis perpendicular to said optical axis and to a rotational axis of said concentration distribution filter.
